# FASCICULE DE BREVET EUROPEEN

(11) **EP 0 601 922 B1**
(45) Date de publication et mention de la délivrance du brevet: **09.04.1997**
(21) Numéro de dépôt: 93402939.8
(22) Date de dépôt: 03.12.1993
(51) Int. Cl.: G11C 16/06, G11C 7/00

(54) **Mémoire EEPROM organisée en mots de plusieurs bits**
Mehrbitwort organisierter EEPROM Speicher
EEPROM memory organised in words of several bits

(30) Priorité: 09.12.1992 FR 9214856
(43) Date de publication de la demande: 15.06.1994
(73) Titulaire: SGS-THOMSON MICROELECTRONICS S.A., 94250 Gentilly (FR)
(72) Inventeur: Guedj, Marc, F-75116 Paris (FR)
(74) Mandataire: Schmit, Christian Norbert Marie

(56) Documents cités:
- EP-A- 0 264 933
- EP-A- 0 412 837
- EP-A- 0 537 083
- FR-A- 2 600 808
- IEEE JOURNAL OF SOLID-STATE CIRCUITS vol. 23, no. 5 , Octobre 1988 , NEW YORK US pages 1150 - 1156 GASTALDI ET AL 'A 1-Mbit CMOS EPROM with Enhanced Verification'

## Description

L'invention concerne les mémoires. Elle concerne plus spécialement les mémoires non volatiles électriquement programmables et électriquement effaçables, bien qu'elle puisse s'appliquer par extension à d'autres types de mémoires volatiles ou non volatiles.

Les mémoires non volatiles programmables et effaçables électriquement, plus communément connues sous le nom de mémoires EEPROM, sont actuellement des mémoires organisées en mots de 1 bit et non en mots de plusieurs bits. La raison en est que ce sont des mémoires de faible capacité (quelques milliers de bits), souvent associées à des circuits de traitement séquentiel des informations binaires. Si ces mémoires sont utilisées dans une application qui nécessite des mots de plusieurs bits, on utilise alors plusieurs puces de mémoire en parallèle recevant les mêmes adresses et fournissant (ou recevant) chacune un bit respectif du mot mémorisé (ou à mémoriser).

Avec le progrès technologique dans le domaine du traitement de l'information, le besoin se fait cependant maintenant sentir de mémoires EEPROM de plus grande capacité (64 kilobits et plus). On peut continuer à travailler avec des mémoires organisées en mots de 1 bit et comportant un plus grand nombre d'adresses. Cependant cela présente deux types d'inconvénients : d'une part c'est peu adapté à des traitements de signaux en parallèle sur des mots de plusieurs bits; d'autre part, dans le cas de mémoires EEPROM, la programmation est relativement lente et consommerait un temps prohibitif si elle n'était pas faite par groupes de plusieurs bits.

On cherche donc à réaliser des mémoires, notamment EEPROM, organisées en mots de p bits (p>1), et ayant donc p entrées/sorties pour recevoir des mots à mémoriser à une adresse donnée ou délivrer des mots mémorisés à cette adresse.

Un des problèmes que l'on rencontre alors est celui de la lecture des mots mémorisés. Une des contraintes est celle de la vitesse d'accès : on cherche à obtenir en sortie de la mémoire, le plus rapidement possible (et évidemment sans que cette rapidité entraîne des erreurs de lecture ou de transmission de l'information lue), un mot mémorisé. L'ordre de grandeur de la vitesse de lecture souhaitée est de quelques dizaines à quelques centaines de nanosecondes par mot. Pour atteindre ces vitesses sans risque de perte de l'information à lire, il faut prendre des précautions aussi bien sur l'organisation générale du réseau de cellules de mémoire que sur la méthode de lecture.

En ce qui concerne l'organisation générale du réseau, en lignes et colonnes, il est connu qu'il est préférable de ne pas avoir des lignes et des colonnes trop longues. En effet, le temps d'accès vers une cellule de mémoire située à une extrémité de ligne loin du décodeur de ligne serait plus long (de plusieurs dizaines de nanosecondes pour une ligne assez longue) que le temps d'accès vers une cellule située à une autre extrémité de ligne près du décodeur. D'autre part, des colonnes trop longues introduisent une capacité parasite de colonne élevée ralentissant globalement le temps de lecture de l'information.

Pour éviter d'avoir des colonnes trop longues, on s'arrange donc pour répartir les mots dans la mémoire de telle manière qu'il y ait plusieurs mots dans chaque ligne. Cela rend d'ailleurs le plan mémoire plus compact. On a alors à la fois un décodeur de ligne pour adresser une ligne parmi n et un décodeur de colonne pour adresser un mot parmi m dans une ligne de m mots de p bits.

De plus, plutôt que le décodeur de ligne soit placé sur un bord de la mémoire, on a déjà proposé de le placer au milieu de la mémoire, entre deux demi-plans de mémoire symétriques par rapport au décodeur. On peut même diviser la mémoire en quatre plans ou plus avec plusieurs demi-décodeurs.

En ce qui concerne la méthode de lecture, en général on effectue la lecture par une méthode différentielle : l'état d'une ligne de bit (c'est-à-dire le conducteur sur lequel apparaît l'information recherchée) est déterminé par comparaison avec l'état d'une ligne de référence qui se comporte comme une ligne de bit, mais une ligne de bit dont on connaîtrait l'information transmise. Dans le cas d'une mémoire EEPROM par exemple, l'information recherchée est un courant de fuite passant ou ne passant pas sur la ligne de bit selon l'information stockée dans la cellule adressée. Ce courant est comparé avec un courant passant dans la ligne de référence. Cette méthode différentielle permet une bonne fiabilité de l'information lue.

De plus, pour améliorer le compromis entre rapidité d'accès à l'information et fiabilité de cette information, on a également proposé de réaliser une lecture en deux phases : dans une première phase, on précharge la ligne de bit et la ligne de référence à une valeur de potentiel moyenne entre deux valeurs extrêmes possibles, et dans une deuxième phase, on effectue la comparaison entre les comportements de la ligne de bit et de la ligne de référence.

Enfin, toujours dans le même but, on a proposé de prévoir également une phase d'équilibrage à l'entrée de l'amplificateur différentiel qui doit servir à effectuer cette comparaison de comportements de la ligne de bit et de la ligne de référence. Cette phase d'équilibrage consiste généralement à mettre en court-circuit la ligne de bit et la ligne de référence (ou les entrées de l'amplificateur différentiel raccordé à ces lignes). De cette manière, l'amplificateur différentiel pourra basculer très rapidement vers un état ou un autre selon l'information lue, et ceci indépendamment de l'état où il a basculé lors de la lecture précédente. En effet, si l'amplificateur restait initialement dans l'état où il a basculé lors de la lecture précédente, il mettrait plus longtemps pour lire un bit de même valeur qu'à la lecture précédente que pour lire un bit de valeur complémentaire, et ceci serait préjudiciable à la rapidité générale de fonctionnement de la mémoire.

Pour toutes les raisons indiquées ci-dessus, les mémoires existant actuellement peuvent présenter une organisation avec n lignes de m mots de p bits, avec éventuellement un décodeur de ligne central plutôt qu'un décodeur latéral, et une méthode de lecture incluant éventuellement des phases de précharge et d'équilibrage.

Un but de l'invention est d'améliorer encore les compromis qui président à la conception des mémoires, surtout des mémoires EEPROM à mots de plusieurs bits; outre les compromis de fiabilité et de vitesse mentionnés ci-dessus, il faut évidemment rajouter les contraintes classiques telles que par exemple la minimisation de la surface physique utilisée par la mémoire dans une puce de circuit intégré.

La demande de brevet Européen EP-A-0 537 083 publiée le 14 avril 1993 décrit un dispositif de ce type.

Autrement dit : dans la technique antérieure, le brevet EP-A-0 537 083 propose de prévoir une seule ligne de référence en utilisant un circuit d'équilibrage qui ne relie pas, et surtout qui ne met pas en court-circuit, une ligne de bit et la ligne de référence, pour ne pas aboutir à une situation de court-circuit général entre les lignes de bit; un tel court-circuit général empêcherait en effet un véritable équilibrage individualisé en fonction des caractéristiques de chaque ligne de bit et chaque amplificateur différentiel.

Un circuit d'équilibrage ayant cette particularité peut fonctionner de préférence en établissant une contre réaction entre la sortie de l'amplificateur différentiel et la ligne de bit associée à cet amplificateur, la contre réaction étant agencée de manière à modifier le potentiel de la ligne de bit dans un sens tendant à annuler la tension de sortie de l'amplificateur.

Le circuit d'équilibrage comporte de préférence un amplificateur suiveur ayant une entrée reliée à la sortie de l'amplificateur différentiel et connecté pendant la phase d'équilibrage de telle manière qu'il injecte un courant de charge de la ligne de bit, ce courant étant dans un sens qui tend à annuler la tension de sortie de l'amplificateur.

L'invention concerne une mémoire en circuit intégré ayant les caractéristiques de la revendication 1.

C'est à dire qu'un premier transistor de précharge est connecté d'un côté à la ligne de bit, un deuxième transistor de précharge est connecté d'un côté à la ligne de référence, et la sortie de l'amplificateur suiveur est connectée pendant la phase d'équilibrage à l'autre côté du premier transistor de précharge. Le premier transistor de précharge est connecté de l'autre côté à la première entrée de l'amplificateur différentiel; le deuxième transistor de précharge est connecté de l'autre côté à la deuxième entrée de l'amplificateur différentiel.

Les transistors de précharge ont de préférence leur grille reliée à un potentiel de référence.

De préférence encore, tout particulièrement dans le cas d'une mémoire EEPROM, la ligne de bit et la ligne de référence sont reliées à des moyens de comparaison de courant permettant de comparer, pendant la phase de lecture, le courant de décharge de la ligne de bit et le courant de décharge de la ligne de référence. Ces moyens de comparaison peuvent comprendre un transistor de référence relié à la ligne de référence par l'intermédiaire du deuxième transistor de précharge, et un transistor de recopie du courant du transistor de référence, le transistor de recopie étant relié à la ligne de bit par l'intermédiaire du premier transistor de précharge.

Enfin, un premier transistor intermédiaire, ayant sa grille reliée à un potentiel fixe, peut être prévu en série entre le transistor de recopie et le premier transistor de précharge. De même, un deuxième transistor intermédiaire, ayant sa grille reliée au même potentiel fixe que le premier transistor intermédiaire, peut être prévu en série entre le transistor de référence et le deuxième transistor de précharge.

D'autres caractéristiques et avantages de l'invention apparaîtront à la lecture de la description détaillée qui suit et qui est faite en référence aux dessins annexés dans lesquels :
- la figure 1 représente la configuration générale d'une mémoire selon l'invention;
- la figure 2 représente une réalisation d'un circuit de lecture de la mémoire;
- la figure 3 représente une variante de réalisation du circuit de lecture.

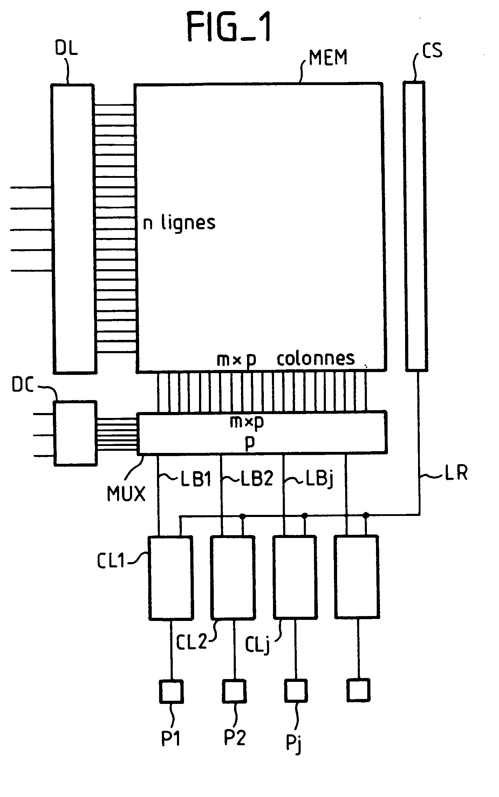

Sur la figure 1 est représentée une mémoire MEM, organisée en n lignes de m mots de p bits. Elle comporte donc :
- un réseau de n lignes de m.p cellules de mémoire, avec n conducteurs de ligne associés chacun à une ligne de cellules pour sélectionner les cellules de cette ligne, et m.p conducteurs de colonnes pour transmettre vers la sortie de la mémoire les informations mémorisées dans les cellules de la ligne sélectionnée,
- un décodeur de lignes DL pour sélectionner une ligne déterminée parmi n,
- un décodeur de colonnes DC pour commander un multiplexeur MUX et sélectionner par ce multiplexeur un groupe de p conducteurs de colonne parmi les m.p conducteurs de colonne,
- p lignes de bit LB1, LB2, etc., connectées par le multiplexeur MUX au groupe de p colonnes sélectionné.
- p circuits de lecture CL1, CL2, etc., ayant chacun une première entrée reliée à une ligne de bit et une deuxième entrée reliée à une ligne de référence LR; chaque circuit de lecture permet de comparer le comportement de la ligne de bit au comportement de la ligne de référence et de fournir un signal de sortie représentant un bit d'information stockée au croisement de la ligne et la colonne sélectionnée; ce signal de sortie est appliqué par exemple à un plot de donnée respectif P1, P2, etc., de la puce de circuit intégré sur lequel la mémoire est réalisée.

La ligne de référence LR est, selon l'invention, commune aux p circuits de lecture. C'est de préférence un conducteur de colonne raccordé à une colonne supplémentaire CS de cellules de mémoire; cette colonne supplémentaire est disposée à côté des colonnes normales de la mémoire et peut être adressée par le même décodeur de ligne DL que les autres cellules. Ceci permet de rendre la ligne de référence aussi semblable que possible à une ligne de bit de la mémoire. Mais les cellules de la ligne de référence sont toutes dans un même état connu (par exemple ce sont toutes des cellules vierges, c'est-à-dire qui n'ont jamais été programmées).

Les circuits autres que les circuits de lecture sont classiques et ne seront pas décrits. Par ailleurs, on n'a pas représenté sur la figure 1, pour ne pas surcharger les explications, les circuits d'écriture, qui sont également classiques et ne sont pas l'objet de la présente invention. Enfin, la figure 1 représente le cas d'une mémoire ayant un décodeur de ligne placé sur le côté du réseau de cellules, mais l'invention s'applique bien entendu également dans le cas des mémoires divisées en deux demi-plans avec le décodeur entre les deux.

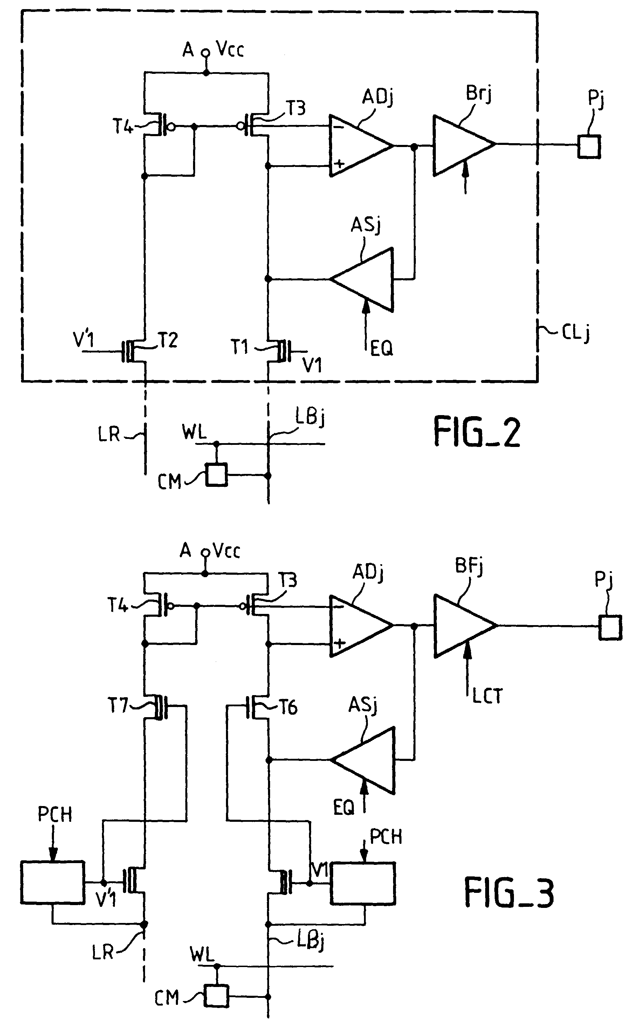

Un circuit de lecture CLj associé à une ligne de bit déterminée LBj est représenté à la figure 2 dans le cas d'une mémoire EEPROM; le circuit est identique pour toutes les lignes de bit mais la ligne de référence est la même pour les p circuits de lecture.

Dans le cas d'une mémoire EEPROM, les cellules de mémoire peuvent avoir un état programmé dans lequel elles peuvent laisser passer un courant électrique, un état effacé dans lequel elles s'opposent au passage du courant, et un état vierge dans lequel elles laissent passer un courant intermédiaire; pour lire l'information on cherche à détecter la présence d'un courant de charge ou de décharge de la ligne de bit reliée à une cellule à lire : un tel courant existe si la cellule est programmée, alors qu'il n'existe pas si la cellule est effacée.

La lecture consiste à comparer le courant de la ligne de bit à celui qui circulerait dans une cellule vierge. Le résultat de la comparaison indique si la cellule lue est effacée ou programmée. Pour cela on utilise la ligne de référence connectée à une colonne de cellules vierges, et on compare directement le courant de la ligne de bit avec le courant de la ligne de référence. Un amplificateur différentiel ADj permet de fournir le résultat de la comparaison.

Le circuit de lecture fonctionne de préférence avec une phase de précharge de la ligne de bit et de la ligne de référence, avant une phase de lecture proprement dite. La ligne de référence et la ligne de bit sont préchargées à un potentiel d'environ 1,9 volt (pour une tension d'alimentation Vcc d'environ 5 volts de la mémoire).

Le circuit de lecture comporte à cet effet un premier transistor de précharge T1 qui a pour fonction de fournir un courant de précharge à la ligne de bit LBj tout en limitant le potentiel de précharge de celle-ci à une valeur déterminée, de préférence aux alentours de 1,9 volt. Un deuxième transistor de précharge T2 permet de précharger de la même manière la ligne de référence LR.

Les transistors T1 et T2 sont de préférence à canal N et à faible tension de seuil (0,2 volt par exemple), leur source est reliée à la ligne à précharger. Pour simplifier, les grilles des transistors sont représentées comme étant reliées à des sources de tension de polarisation V1 et V'1. La valeur de la tension V1 définit la limite supérieure du potentiel de précharge des lignes LBj et LR.

Les drains des transistors de précharge T1 et T2 sont alimentés par les deux branches d'un miroir de courant de rapport de recopie k égal à 1. La première branche du miroir comprend un transistor de recopie T3; la deuxième branche comprend un transistor de référence T4. Le transistor de recopie tend à recopier le courant qui circule dans le transistor de référence.

Le transistor de recopie T3 est un transistor à canal P ayant sa source reliée à la borne de tension d'alimentation haute ( borne A à Vcc) du circuit; celle-ci est en général à +5 volts environ au dessus d'une borne d'alimentation basse. Le drain du transistor de recopie est relié au drain du premier transistor de précharge T1.

Le transistor de référence T4 est de la même façon un transistor à canal P, de géométrie identique à T3, dont la source est reliée à la borne A et dont le drain est relié au drain du deuxième transistor de précharge T2.

Les grilles des transistors T3 et T4 sont réunies et la grille du transistor de référence est reliée à son drain (montage en diode). On a donc un schéma classique de recopie de courant.

L'amplificateur différentiel ADj a ses entrées reliées aux drains des transistors T3 et T4 et mesure donc l'écart entre les potentiels sur ces deux drains. Cet écart est nul si les courants dans T3 et T4 sont égaux. Il diffère de zéro si le rapport des courants diffère de 1. La sortie de l'amplificateur ADj fournit un signal qui indique si le rapport des courants est supérieur ou inférieur à 1, et qui indique par conséquent si la ligne de bit LBj est reliée à une cellule CM programmée ou effacée.

Avant d'effectuer une phase de lecture, on effectue d'abord une phase d'équilibrage de la ligne de bit et de la ligne de référence. Cette phase d'équilibrage permet de ramener l'écart de tension différentielle à l'entrée de l'amplificateur ADj à une valeur aussi proche que possible de zéro quel que soit l'état logique lu dans une cellule de mémoire à la phase de lecture précédente. Dans la technique antérieure, cette phase d'équilibrage consistait à court-circuiter, par un transistor rendu conducteur pendant la phase d'équilibrage, les deux entrées de l'amplificateur différentiel, ce qui revient à relier ou pratiquement à court-circuiter la ligne de bit et la ligne de référence. Cette solution était compatible avec une architecture de mémoire à mots de 1 bit seulement, ou avec des architectures de mémoires à mots de plusieurs bits mais ayant alors autant de lignes de référence que de lignes de bit.

Selon l'invention, on utilise un circuit d'équilibrage qui ne relie pas la ligne de bit et la ligne de référence par des éléments conducteurs, ce qui permet d'avoir une ligne de référence unique pour l'ensemble des circuits de lecture.

Le circuit d'équilibrage CLj associé à la ligne de bit LBj comporte essentiellement un amplificateur suiveur ASj, dont l'entrée est reliée à la sortie S de l'amplificateur différentiel ADj, et dont la sortie est reliée au drain de l'un des transistors de précharge, de préférence le transistor T1 qui est relié à la ligne de bit correspondant à la cellule à lire.

Cet amplificateur suiveur ASj n'est activé que pendant une phase d'équilibrage EQ précédant la phase de lecture LCT. Pendant les autres phases, c'est-à-dire plus spécialement pendant la phase de lecture, sa sortie se comporte comme une haute impédance, de manière à ne pas prélever ou injecter de courant dans la première branche du miroir de courant. Une commande d'activation de l'amplificateur suiveur reçoit un signal d'horloge définissant la phase d'équilibrage EQ.

Cet amplificateur suiveur constitue l'élément principal d'une boucle de contre réaction qui modifie la précharge de la ligne de bit pour augmenter ou diminuer le potentiel d'une entrée de l'amplificateur différentiel ADj, dans un sens tendant à annuler la tension de sortie de l'amplificateur différentiel.

On peut considérer que l'activation de l'amplificateur suiveur ASj agit comme une précharge complémentaire, de sorte qu'il n'est même pas forcément nécessaire de prévoir deux phases distinctes (précharge et équilibrage) avant la phase de lecture; une phase d'équilibrage unique peut être prévue puisqu'elle agit de la même manière qu'une phase de précharge tout en assurant la fonction d'équilibrage.

C'est pourquoi on a représenté les grilles de commande de T1 et T2 commandées par un simple potentiel de polarisation fixe V1, V'1, et non pas par un circuit activé pendant une phase de précharge.

Les transistors T1 et T2 agissent, comme à la figure 1, comme limiteurs de tension pour limiter la tension de précharge de la ligne de bit et de la ligne de référence aux alentours de 1,9 volt.

Le circuit fonctionne de la manière suivante pendant la phase de précharge la ligne de bit et la ligne de référence sont portées à un potentiel d'environ 1 volt. La valeur de la tension V1 appliquée pendant la précharge permet de contrôler cette valeur de potentiel. Puis, pendant la phase d'équilibrage, l'amplificateur suiveur ASj est activé et modifie la charge de la ligne de bit en fonction de l'état de la sortie de l'amplificateur différentiel. La modification de charge de la ligne de bit tend à ramener à zéro la sortie de l'amplificateur ADj. On obtient ainsi un équilibrage de l'amplificateur différentiel juste avant la phase de lecture. La sortie de l'amplificateur fournit alors pratiquement une tension nulle quel que soit l'état logique pris par cette sortie à la lecture précédente.

Pendant la phase de lecture l'amplificateur suiveur est désactivé (sortie en haute impédance). L'application d'une tension de lecture sur la ligne de mot a deux effets possibles :
- si la cellule lue est programmée, elle tend à décharger la ligne de bit avec un courant Ip. Mais le miroir de courant impose un courant Ir (avec Ir inférieur à Ip) dans la ligne de bit, puisque simultanément un courant Ir circule dans la ligne de référence connectée à une cellule vierge. Le drain du transistor T1 tend à tomber à un potentiel nul alors que le drain du transistor T2 reste à environ une tension de seuil au dessous de la tension d'alimentation Vcc. L'amplificateur différentiel ADj bascule dans un premier état.
- si la cellule lue est effacée, elle ne laisse pas passer de courant de décharge de la ligne de bit, alors que le transistor de recopie T3 tend à imposer un courant de décharge Ir; Le transistor T3 se sature et tend à monter le potentiel du drain de T1 à Vcc. L'amplificateur différentiel AD bascule dans l'autre sens.

Un amplificateur tampon, BFj, activé pendant la phase de lecture LCT, transmet à un plot Pj l'état de la sortie de l'amplificateur différentiel ADj.

Dans une réalisation améliorée, visible à la figure 3, on a intercalé un transistor supplémentaire T6 entre le drain du transistor de précharge T1 et le drain du transistor de recopie T3; et de même un transistor T7 entre le drain du transistor de précharge T2 et le drain du transistor de référence T4. Les entrées de l'amplificateur différentiel ADj sont connectées aux drains des transistors T3 et T4 du miroir de courant, comme à la figure 2.

Ces transistors T6 et T7 sont montés en cascade, c'est-à-dire qu'ils ont leur grille à un potentiel constant qui les rend conducteurs. De préférence ce sont des transistors à canal N et à très faible tension de seuil (0,2 volt), dont la grille est reliée au potentiel V1 pour T1 et au potentiel V'1 pour T2. La sortie de l'amplificateur suiveur ASj est reliée au point de jonction du transistor de précharge T1 et du transistor supplémentaire T6.

L'avantage de ces transistors est qu'ils introduisent une grande impédance résistive en dynamique entre la ligne de bit et les entrées de l'amplificateur différentiel. Cette impédance établit un découplage entre le drain du transistor T1 (présentant une forte capacité parasite à cause de la présence de l'amplificateur suiveur) et l'entrée de l'amplificateur différentiel (présentant une faible capacité parasite).

Il en résulte que le déséquilibre de tensions qui apparaît sur la ligne de bit lors de la phase de lecture se retransmet fortement amplifié aux bornes de l'amplificateur différentiel. La lecture est donc accélérée.

## Revendications

1. Mémoire en circuit intégré, organisée en mots de p bits, p>1, avec p lignes de bit pour relier les p cellules d'un mot à lire à des premières entrées de circuits de lecture (CLj) associés respectivement à chacune de ces lignes de bit, ces circuits de lecture ayant une deuxième entrée reliée à une ligne de référence (LR) la ligne de référence (LR) étant commune aux p circuits de lecture d'un mot, ces circuits de lecture comportant chacun un amplificateur différentiel (ADj), la mémoire comportant par ailleurs un circuit d'équilibrage respectif pour chaque circuit de lecture, ayant pour fonction de ramener l'écart de tension différentielle à l'entrée de l'amplificateur différentiel (ADj) à une valeur aussi proche que possible de zéro pour tendre à annuler la tension de sortie de l'amplificateur différentiel associé sans relier, par des éléments conducteurs de courant, la ligne de bit concernée par ce circuit d'équilibrage et la ligne de référence, pendant une phase d'équilibrage précédant une phase de lecture, chaque circuit d'équilibrage comportant un amplificateur suiveur (ASj) ayant une entrée reliée à la sortie de l'amplificateur différentiel et une sortie connectée pendant la phase d'équilibrage de telle manière qu'il injecte un courant de charge de la ligne de bit dans un sens tendant à annuler la tension de sortie de l'amplificateur, et chaque circuit de lecture comportant un premier transistor de précharge (T1) connecté d'un côté à la ligne de bit (LBj), un deuxième transistor de précharge (T2) connecté d'un côté à la ligne de référence (LR), la sortie de l'amplificateur suiveur étant connectée pendant la phase d'équilibrage à l'autre côté du premier transistor de précharge.

2. Mémoire selon la revendication 1, caractérisée en ce que les transistors de précharge ont leur grille reliée à un potentiel de référence (V1) pendant la phase de précharge.

3. Mémoire selon l'une des revendications 1 à 2, caractérisée en ce que la ligne de bit et la ligne de référence sont reliées à des moyens de comparaison de courant (T3, T4) permettant de comparer, pendant la phase de lecture, le courant de décharge de la ligne de bit et le courant de décharge de la ligne de référence.

4. Mémoire selon la revendication 3, caractérisée en ce que les moyens de comparaison comprennent un transistor de référence (T4) relié à la ligne de référence par l'intermédiaire du deuxième transistor de précharge (T2), et un transistor (T3) de recopie du courant du transistor de référence, le transistor de recopie étant relié à la ligne de bit par l'intermédiaire du premier transistor de précharge (T1).

5. Mémoire selon la revendication 4, caractérisée en ce que le premier transistor de précharge est connecté de l'autre côté à la première entrée de l'amplificateur différentiel et le deuxième transistor de précharge est connecté de l'autre côté à la deuxième entrée de l'amplificateur différentiel.

6. Mémoire selon la revendication 4, caractérisé en ce qu'un premier transistor intermédiaire (T6) ayant sa grille reliée à un potentiel fixe est relié en série entre le transistor de recopie et le premier transistor de précharge.

7. Mémoire selon la revendication 6 caractérisée en ce que le premier transistor intermédiaire (T6) est à canal N et a sa grille reliée à la grille du premier transistor de précharge (T1).

8. Mémoire selon l'une des revendications 6 et 7, caractérisée en ce qu'un deuxième transistor intermédiaire (T7) ayant sa grille reliée à la grille du deuxième transistor de précharge (T2) est relié en série entre le transistor de référence et le deuxième transistor de précharge.

## Patentansprüche

1. Speicher in Form eines integrierten Schaltkreises, der in Worte von p Bit, p > 1 unterteilt ist, mit p Bitleitungen für die Verbindung der p Zellen eines zu lesenden Wortes mit den ersten Eingängen von Leseschaltkreisen (CLj), die jeweils zu jeder der Bitleitungen gehören, wobei die Leseschaltkreise einen zweiten Eingang haben, der mit einer Referenzleitung (LR) verbunden ist, wobei die Referenzleitung (LR) allen p Wortleseschaltkreisen gemeinsam ist, wobei die Leseschaltkreise jeweils einen Differenzverstärker (ADj) umfassen, wobei der Speicher im übrigen einen jeweiligen Ausgleichsschaltkreis für jeden Leseschaltkreis umfaßt, dessen Funktion es ist, den differentiellen Spannungsunterschied am Eingang des Differenzverstärkers (ADj) auf einen Wert zu bringen, der so nahe wie möglich bei Null liegt, um die Ausgangsspannung des dazugehörigen Differenzverstärkers auf Null zu bringen, ohne mittels Stromleiterelementen über diesen Ausgleichsschaltkreis die betroffene Bitleitung und die Referenzleitung während einer Ausgleichsphase vor einer Lesephase zu verbinden, wobei jeder Ausgleichsschaltkreis einen Zusatzverstärker (ASj) mit einem Eingang, der mit dem Ausgang des Differenzverstärkers verbunden ist, und mit einem Ausgang, der während der Ausgleichsphase geschaltet ist, so daß er einen Ladungsstrom der Bitleitung in der Richtung injiziert, so daß die Ausgangsspannung des Verstärkers annulliert wird, umfaßt, und jeder Leseschaltkreis einen ersten Transistor zum Vorladen (T1), der auf einer Seite mit der Bitleitung (LBj) verbunden ist, und einen zweiten Transistor zum Vorladen (T2) umfaßt, der auf einer Seite mit der Referenzleitung (LR) verbunden ist, wobei der Ausgang des Zusatzverstärkers während der Ausgleichsphase mit der anderen Seite des ersten Transistors zum Vorladen verbunden ist.

2. Speicher nach Anspruch 1, dadurch gekennzeichnet, daß die Transistoren zum Vorladen über ihr Gitter mit einem Referenzpotential (V1) während der Vorladephase verbunden sind.

3. Speicher nach einem der Ansprüche 1 oder 2, dadurch gekennzeichnet, daß die Bitleitung und die Referenzleitung über Stromvergleicher (T3, T4) verbunden sind, welche während der Lesephase den Vergleich des Entladestroms der Bitleitung und des Entladestroms der Referenzleitung ermöglichen.

4. Speicher nach Anspruch 3, dadurch gekennzeichnet, daß die Vergleichervorrichtungen einen Referenztransistor (T4), der mit der Referenzleitung über den zweiten Transistor zum Vorladen (T2) verbunden ist, und einen Transistor (T3) zum Spiegeln des Stromes durch den Referenztransistor umfassen, wobei der Spiegeltransistor mit der Bitleitung über den ersten Transistor zum Vorladen (T1) verbunden ist.

5. Speicher nach Anspruch 4, dadurch gekennzeichnet, daß der erste Transistor zum Vorladen auf seiner anderen Seite mit dem ersten Eingang des Differenzverstärkers verbunden ist und der zweite Transistor zum Vorladen auf der anderen Seite mit dem zweiten Eingang des Differenzverstärkers verbunden ist.

6. Speicher nach Anspruch 4, dadurch gekennzeichnet, daß ein erster Zwischentransistor (T6), der mit seinem Gitter mit einem festen Potential verbunden ist, in Serie zwischen dem Spiegeltransistor und dem ersten Transistor zum Vorladen geschaltet ist.

7. Speicher nach Anspruch 6, dadurch gekennzeichnet, daß der erste Zwischentransistor (T6) ein N-Kanal-Transistor ist und über sein Gitter mit dem Gitter des ersten Transistors zum Vorladen (T1) verbunden ist.

8. Speicher nach einem der Ansprüche 6 und 7, dadurch gekennzeichnet, daß ein zweiter Zwischentransistor (T7), der über sein Gitter mit dem Gitter des zweiten Transistors zum Vorladen (T2) verbunden ist, in Serie zwischen Referenztransistor und dem zweiten Transistor zum Vorladen geschaltet ist.

## Claims

1. Integrated circuit memory, organised in words of p bits, p>1, with p bit lines for connecting the p cells of a word to be read to first inputs of read circuits (CLj) associated respectively with each of these bit lines, these read circuits having a second input connected to a reference line (LR), the reference line (LR) being common to the p read circuits of a word, these read circuits each having a differential amplifier (ADj), the memory also including a respective balancing circuit for each read circuit, having the function of returning the differential voltage difference at the input of the differential amplifier (ADj) to a value as close as possible to zero in order to tend to cancel the output voltage of the associated differential amplifier without connecting, through current-conducting components, the bit line to which this balancing circuit relates and the reference line, during a balancing phase preceding a read phase, each balancing circuit including a follower amplifier (AFj) having an input connected to the output of the differential amplifier and an output connected during the balancing phase so that it injects a current charging the bit line in a direction tending to cancel the output voltage of the amplifier, and each read circuit including a first precharge transistor (T1) connected on one side to the bit line (LBj), a second precharge transistor (T2) connected on one side the reference line (LR), the output of the follower amplifier being connected during the balancing phase to the other side of the first precharge transistor.

2. Memory according to Claim 1, characterised in that the precharge transistors have their gate connected to a reference potential (V1) during the precharge phase.

3. Memory according to one of Claims 1 to 2, characterised in that the bit line and reference line are connected to current comparison means (T3, T4) for comparing, during the read phase, the discharge current of the bit line and the discharge current of the reference line.

4. Memory according to Claim 3, characterised in that the comparison means comprise a reference transistor (T4) connected to the reference line by means of the second precharge transistor (T2), and a transistor (T3) mirroring the current of the reference transistor, the mirroring transistor being connected to the bit line by means of the first precharge transistor (T1).

5. Memory according to Claim 4, characterised in that the first precharge transistors connected on the other side to the first input of the differential amplifier and the second precharge transistor is connected on the other side to the second input of the differential amplifier.

6. Memory according to Claim 4, characterised in that a first intermediate transistor (T6) having its gate connected to a fixed potential is connected in series between the mirroring transistor and the first precharge transistor.

7. Memory according to Claim 6, characterised in that the first intermediate transistor (T6) is of the n-channel type and has its gate connected to the gate of the first precharge transistor (T1).

8. Memory according to one of Claims 6 and 7, characterised in that a second intermediate transistor (T7) having its gate connected to the gate of the second precharge transistor (T2) is connected in series between the reference transistor and the second precharge transistor.
